# FASCICULE DE BREVET EUROPEEN

(11) **EP 2 577 864 B1**
(45) Date de publication et mention de la délivrance du brevet: **02.03.2016**
(21) Numéro de dépôt: 11723419.5
(22) Date de dépôt: 24.05.2011
(51) Int. Cl.: G02F 1/11, H03B 17/00, G02F 1/35, H03B 21/02

(54) **OSCILLATEUR GENERANT UN SIGNAL COMPORTANT UNE FREQUENCE DE L'ORDRE DU TERA HERTZ A BASE D'UN BATTEMENT DE DEUX ONDES OPTIQUES**
OSZILLATOR ZUR ERZEUGUNG EINES SIGNALS MIT EINER TERAHERTZ-FREQUENZ ANHAND DER SCHWEBUNG VON ZWEI OPTISCHEN WELLEN
OSCILLATOR FOR GENERATING A SIGNAL COMPRISING A TERAHERTZ-ORDER FREQUENCY USING THE BEAT OF TWO OPTICAL WAVES

(30) Priorité: 02.06.2010 FR 1054281
(43) Date de publication de la demande: 10.04.2013
(73) Titulaire: Université de Rennes 1, 35065 Rennes Cedex (FR); Centre National de la Recherche Scientifique (CNRS), 75016 Paris (FR)
(72) Inventeur: ALOUINI, Mehdi, F-35340 Liffre (FR); LOAS, Goulc'hen, F-35250 Saint Aubin d'Aubigné (FR); BONDU, François, F-35530 Servon sur Vilaine (FR); VALLET, Marc, F-35235 Thorigné Fouillard (FR); BRUNEL, Marc-Olivier, F-35200 Rennes (FR); ROMANELLI, Marco, F-35000 Rennes (FR)
(74) Mandataire: Maillet, Alain
(86) Numéro de dépôt international: PCT/EP2011/058450
(87) Numéro de publication internationale: WO 2011/151223

(56) Documents cités:
- US-A- 5 574 588
- US-B1- 6 239 893
- RUOSO G ET AL: "Nd:YAG laser frequency stabilization to a supercavity at the 0.1 Hz level", OPTICS COMMUNICATIONS, NORTH-HOLLAND PUBLISHING CO. AMSTERDAM, NL, vol. 133, no. 1, 1 janvier 1997 (1997-01-01), pages 259-262, XP004015702, ISSN: 0030-4018, DOI: DOI:10.1016/S0030-4018(96)00444-0
- SHUJI MATSUURA ET AL: "A Tunable Cavity-Locked Diode Laser Source for Terahertz Photomixing", IEEE TRANSACTIONS ON MICROWAVE THEORY AND TECHNIQUES, IEEE SERVICE CENTER, PISCATAWAY, NJ, US, vol. 48, no. 3, 1 March 2000 (2000-03-01), XP011037912, ISSN: 0018-9480

## Description

La présente invention concerne un oscillateur générant une onde composée d'une fréquence de l'ordre du Tera Hertz à partir d'un battement stabilisé de deux ondes optiques générées par une source optique bi-fréquence.

La génération et le contrôle d'ondes Tera Hertz (THz) est un domaine qui connaît aujourd'hui un regain d'intérêt grâce aux progrès de la microélectronique d'une part, et de l'optique d'autre part.

Les ondes THz couvrent le spectre électromagnétique compris entre les micro ondes et l'infrarouge lointain.

Les applications visées sont par exemple l'imagerie, la spectroscopie, la détection d'espèces chimiques et biologiques et la physique des interactions phonon matière et phonon lumière.

Différentes techniques sont actuellement mises en oeuvre pour générer des ondes THz.

La plus répandue repose sur l'utilisation d'un laser impulsionnel femto seconde associé à une antenne à base de semi conducteurs dont la durée de vie des porteurs est de l'ordre de la pico seconde ou sur l'utilisation d'un cristal à rectification optique. L'onde ainsi générée s'étale sur une largeur spectrale pouvant atteindre quelques THz. Cette technique ne permet pas d'obtenir une onde THz de grande pureté spectrale.

Un exemple de l'état de la technique pour générer une onde dans la région spectrale de THz est présenté dans l'article "A Tunable Cavity-Locked Diode Laser Source for Terahertz Photomixing", par S. Matsuura (IEEE Transactions of Microwave Theory and techniques, IEEE Service Center, Piscataway, NJ, US, vol. 48, no. 3, mars 2000). Il décrit le contrôle de deux sources lasers à base du produit de battement des deux ondes optiques.

D'autres techniques utilisent des techniques de multiples multiplications d'une fréquence micro-onde pour arriver à une onde THz. Ces techniques sont relativement compliquées à mettre en oeuvre.

L'invention a pour but de résoudre les inconvénients de l'art antérieur en proposant un générateur d'ondes THz de grande pureté spectrale.

A cette fin, selon un premier aspect, l'invention propose un oscillateur selon la revendication 1.

Ainsi, en créant une boucle de contre réaction dans l'oscillateur, il est possible de contrôler précisément la fréquence d'au moins une des ondes optiques générées par l'oscillateur. Il est alors possible d'obtenir un générateur d'ondes THz de grande pureté spectrale.

En insérant un modulateur dont la fonction de transfert est non linéaire pour générer des harmoniques d'une fréquence inférieure au Tera Hertz pour chacune des ondes optiques générées par la source optique bi-fréquence, en détectant au moins une harmonique pour chacune des ondes optiques générée par la source optique bi-fréquence et en transformant les harmoniques détectées en un signal électrique, il est possible d'obtenir des signaux comprenant des informations représentatives de l'onde THz à des fréquences beaucoup plus faibles.

De plus, en faisant varier la fréquence du signal électrique de consigne et/ou la fréquence de modulation du modulateur non linéaire, il est possible de faire varier la fréquence de l'onde THz tout en gardant une grande pureté spectrale quelle que soit la fréquence de l'onde THz.

La présente invention permet ainsi d'obtenir un générateur d'onde THz dont la fréquence est variable.

Selon un mode particulier de l'invention, l'oscillateur comporte en outre des moyens de filtrage du signal optique délivré par le modulateur.

Ainsi, il est possible de supprimer les deux ondes optiques générées par la source optique bi-fréquence qui ont une intensité importante en comparaison avec les harmoniques. La détection des harmoniques est alors plus précise.

Selon un mode particulier de l'invention, l'oscillateur comporte en outre des moyens d'amplification optique du signal optique délivré par le modulateur et/ou des moyens d'amplification optique du signal optique délivré par le modulateur et filtré.

Ainsi, la détection des harmoniques est alors plus précise.

Selon un mode particulier de l'invention, la source optique bi-fréquence est un laser bi-fréquence oscillant simultanément sur deux modes et l'élément de la source optique bi-fréquence commandé est un matériau électro-optique intra-cavité.

Ainsi, il est possible d'ajuster à l'aide d'une tension électrique la différence de fréquence optique et, par conséquent, le battement à une fréquence de l'ordre du THz.

Selon un mode particulier de l'invention, la source optique bi-fréquence est constituée de deux lasers monomodes, et l'élément de la source optique bi-fréquence commandé est un des lasers dont le courant d'injection est commandé ou dont le contrôleur de température est commandé ou l'élément de la source optique bi-fréquence commandé est un module piézo-électrique placé sur un des miroirs dudit laser.

Ainsi, il est possible d'ajuster à l'aide d'une tension électrique la différence de fréquence optique et, par conséquent, le battement à une fréquence de l'ordre du THz.

Selon un mode particulier de l'invention, l'oscillateur comporte en outre des moyens de filtrage et/ou d'amplification et/ou de déphasage du signal électrique résultant de la comparaison.

Ainsi, seul le signal issu du battement entre les harmoniques, par exemple les plus proches, est pris en compte pour l'asservissement.

Selon un mode particulier de l'invention, la sortie de la source optique bi-fréquence est reliée à une antenne.

Ainsi, il est possible de convertir le battement optique THz préalablement asservi en rayonnement THz de grande pureté spectrale.

Selon un mode particulier de l'invention, le signal électrique obtenu par transformation des harmoniques détectées est un signal de battement.

Un signal de battement est une combinaison de deux signaux à des fréquences différentes.

Selon un mode particulier de l'invention, le modulateur dont la fonction de transfert est non linéaire est un modulateur de Mach-Zehnder, un modulateur de phase, un amplificateur à semi conducteur modulé à F_{RF} via son courant d'injection ou via un battement optique, un résonateur optique de type Fabry-Perot comportant un modulateur de phase ou d'amplitude, un résonateur optique en anneau comportant un modulateur de phase ou d'amplitude.

Selon un mode particulier de l'invention, l'oscillateur comporte en outre un polariseur pour générer un battement des ondes optiques.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
la Fig. 1 représente un générateur d'onde THz selon la présente invention ;
la Fig. 2 représente un exemple de source optique bi-fréquence selon la présente invention ;
la Fig. 3 représente un exemple des différentes longueurs d'ondes générées par la source optique bi-fréquence en fonction de l'orientation des étalons compris dans la source optique bi-fréquence ;
la Fig. 4 est en exemple de fonction de transfert non linéaire d'un modulateur Mach-Zehnder non linéaire utilisé dans la présente invention ;
la Fig. 5 représente le spectre en fréquence en sortie du modulateur non linéaire.

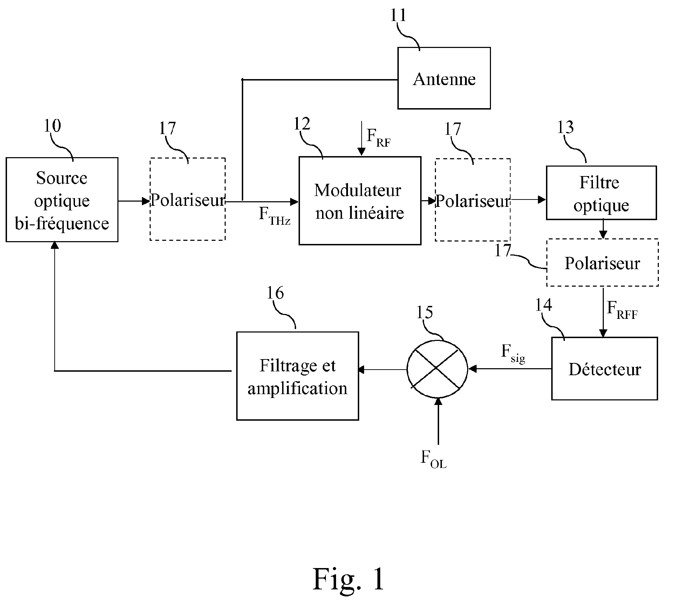

La **Fig. 1** représente un générateur d'onde THz selon la présente invention.

Le générateur d'onde THz comporte une source optique bi-fréquence 10, une antenne 11, un modulateur non linéaire 12, un détecteur optique 14 et un asservissement en phase d'une des fréquences de la source optique.

La source optique bi-fréquence 10 génère deux ondes optiques dont la différence de fréquence F_{THz} se situe dans le domaine du THz. La source optique bi-fréquence 10 est par exemple constituée de deux lasers monomodes ou d'un laser impulsionnel à verrouillage de mode duquel deux modes optiques sont prélevés ou d'un laser bi-fréquence oscillant simultanément sur deux modes tels que par exemple le laser décrit dans la publication de M Alouini intitulé « Dual tunable wavelenght Er :Yb :glass for THz beat frequency generation » publié dans la revue IEEE Photon. Technol. Lett.10, 1554 (1998).

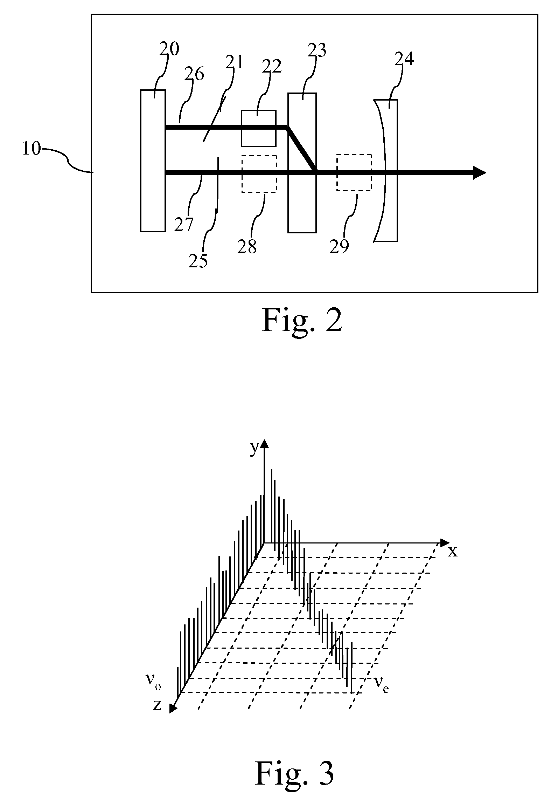

La source optique bi-fréquence 10 sera décrite plus en détail en référence à la Fig. 2.

La **Fig. 2** représente un exemple de source optique bi-fréquence selon la présente invention.

La source optique bi-fréquence 20 oscille sur deux ondes de polarisation orthogonales. L'onde optique 26 de fréquence νₑ traverse un étalon 21 qui garantit l'oscillation monomode et permet de sélectionner de manière grossière la longueur d'onde. L'onde optique 27 de fréquence νₒ traverse un étalon 25 qui garantit l'oscillation monomode et permet de sélectionner de manière grossière la deuxième longueur d'onde.

Les deux ondes optiques 26 et 27 sont combinées par un cristal séparateur de polarisation 23 . L'oscillation laser des deux fréquences νₒ et νₑ a lieu entre les miroirs 20 et 24.

Selon l'invention, la source optique bi-fréquence 10 comporte un matériau électro-optique 22 dont les indices électro-optiques varient selon la tension électrique qui lui est appliquée.

Le matériau électro-optique est selon un mode particulier de l'invention un cristal électro-optique.

En variante, le matériau électro-optique est du verre électro-optique ou de la céramique électro-optique.

Le matériau électro-optique 22 est par exemple traversé par l'onde optique 26 de fréquence νₑ.

En variante, le matériau électro-optique 22 est placé dans les zones 28 et 29 en pointillé sur la Fig. 1.

Lorsque la tension appliquée au matériau électro-optique 22 varie, la fréquence de l'onde optique le traversant varie.

Le matériau électro-optique permet d'ajuster finement une fréquence optique en fonction de la tension qui lui est appliquée.

La **Fig. 3** représente un exemple des différentes longueurs d'ondes générées par la source optique bi-fréquence en fonction de l'orientation des étalons compris dans la source optique bi-fréquence.

Dans l'exemple de la Fig. 3, la fréquence νₑ de l'onde optique 26 varie en fonction de l'orientation de l'étalon 21.

Les étalons 21 et 25 permettent de sélectionner des longueurs d'ondes par sauts de modes de c/2L : c étant la vitesse de la lumière et L la longueur de la cavité comprise entre les miroirs 20 et 24. Le matériau électro-optique 22 permet quant à lui d'accorder finement et de manière continue la plage c/2L.

L'axe des x représente les variations de fréquences tandis que l'axe y représente les intensités des ondes optiques 26 et 27.

L'axe z représente l'évolution des ondes optiques dans le temps lorsque l'orientation d'un des étalons est changée.

Dans l'exemple de la Fig. 3, l'onde optique 26 de fréquence νₑ traverse l'étalon 21 et la fréquence de celle-ci varie en fonction de l'inclinaison de l'étalon 21 tandis que la fréquence νₒ de l'onde optique 27 reste constante.

La sortie de la source optique bi-fréquence 10 est reliée à l'antenne 11 et au modulateur non linéaire 12 ou, via un polariseur 17, à l'antenne 11 et au modulateur non linéaire 12 lorsque la source optique bi-fréquence est telle que celle décrite en référence à la Fig. 2.

L'antenne 11 est une antenne dipôle ou spirale.

Par exemple et de manière non limitative, l'antenne 11 est un motif métallique déposé sur un substrat semi-conducteur d'AsGa-BT ou d'InGaAs-BT. Le battement optique génère dans le semi-conducteur des porteurs dont la durée de vie est suffisamment courte pour suivre l'enveloppe de modulation optique à la fréquence THz.

L'antenne peut aussi fonctionner sur le principe de la rectification optique. Dans ce cas, les non-linéarités optiques sont mises à profit pour générer le rayonnement THz.

Le polariseur 17 est représenté en traits pointillés dans la Fig. 1.

Le polariseur 17 est un polariseur à quarante cinq degrés des axes de polarisation des ondes optiques. Le polariseur 17 permet d'obtenir un battement des ondes optiques. Les ondes optiques sont projetées sur l'axe du polariseur 17 de manière à ce que les deux ondes optiques interfèrent et donnent un battement.

Dans l'exemple de la fig. 1, le polariseur 17 est placé en sortie de la source optique bi-fréquence.

En variante, le polariseur 17 est placé en sortie du modulateur non linéaire 12 ou avant le détecteur optique 14.

Le modulateur non linéaire 12 est un dispositif permettant de moduler l'intensité ou la phase de l'onde bi-fréquence à une fréquence radio ou micro onde, par exemple à une fréquence de l'ordre du Giga Hertz notée F_{RF}.

Le modulateur non linéaire 12 possède une fonction de transfert optique dont la non linéarité est très marquée de manière à générer une pluralité d'harmoniques de la fréquence F_{RF}. Le modulateur non linéaire 12 est par exemple un modulateur Mach-Zehnder, un modulateur de phase, un amplificateur à semi conducteur modulé à F_{RF} via son courant d'injection ou via un battement optique, un résonateur optique de type Fabry-Perot comportant un modulateur de phase ou d'amplitude, un résonateur optique en anneau comportant un modulateur de phase ou d'amplitude.

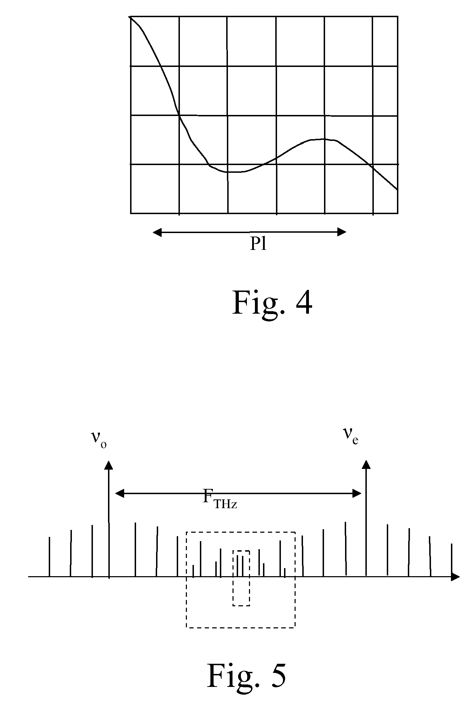

La **Fig. 4** est un exemple de fonction de transfert d'un modulateur Mach-Zehnder non linéaire utilisé dans la présente invention.

L'axe des abscisses représente les différentes tensions de modulation appliquées au modulateur non linéaire 12 et l'axe des ordonnées représente la transmission du signal optique. La plage de variation de la tension de modulation est représentée par la zone P1 et comprend des zones de non linéarité.

La **Fig. 5** représente le spectre en fréquence en sortie du modulateur non linéaire.

La non linéarité de la fonction de transfert du modulateur non linéaire 12 fait apparaître dans le spectre optique de part et d'autre des fréquences des deux ondes νₑ et νₒ une multitude d'harmoniques à des fréquences multiples de F_{RF}.

Le signal de sortie du modulateur non linéaire 12 est converti en un signal électrique par un détecteur optique 14 tel qu'une photodiode.

Selon un mode préféré de l'invention, le signal de sortie du modulateur non linéaire 12 est filtré par un filtre optique 13 de manière à obtenir au moins une fréquence harmonique issue de l'onde optique 27 de fréquence νₒ et une fréquence harmonique issue de l'onde optique 26 de fréquence νₑ.

Il est à remarquer ici que dans une variante de réalisation de la présente invention, le signal de sortie du modulateur non linéaire est amplifié avant d'être filtré et/ou le signal de sortie du modulateur non linéaire 12 est amplifié après avoir été filtré.

Les carrés en pointillés sur la Fig. 5 représentent deux exemples d'harmoniques qui sont filtrées et converties en un signal électrique par le détecteur optique 14.

Deux harmoniques ont des fréquences respectives égales à νₘ= νₒ+ mF_{RF} et νₙ= νₑ- nF_{RF} où m et n sont deux entiers.

Il est à remarquer ici que la fréquence de modulation F_{RF} est choisie de sorte que F_{SIG}= νₙ- νₘ se situe dans une plage de fréquence comprise entre quelques kiloHertz à quelques GigaHertz.

Le battement de ces au moins deux fréquences est ensuite converti en un signal électrique F_{SIG} qui est comparé par un comparateur de phase 15 à un oscillateur local F_{OL} dont la fréquence est comprise entre quelques dizaines de kiloHertz et quelques GigaHertz.

Le résultat de la comparaison est représentatif de l'erreur de phase de l'onde THz.

Le résultat de la comparaison est ensuite préférentiellement filtré et/ou amplifié et/ou déphasé par un module de filtrage et d'amplification 16 pour être ensuite appliqué au matériau électro-optique 22.

Il est à remarquer ici que si la source optique bi-fréquence est constituée de deux lasers monomodes, le résultat de la comparaison filtré et/ou amplifié et/ou déphasé est transféré sur un des lasers via son courant d'injection ou son contrôleur de température ou encore via un module piézo-électrique placé sur un des miroirs du laser.

Bien entendu, la présente invention n'est nullement limitée aux modes de réalisation décrits ici, mais englobe, bien au contraire, toute variante à la portée de l'homme du métier et particulièrement la combinaison de différents modes de réalisation de la présente invention.

## Revendications

1. Oscillateur générant une onde composée d'une fréquence de l'ordre du Tera Hertz à partir d'un battement de deux ondes aux fréquences respectives **ν**ₒ et **ν**ₑ générées par une source optique bi-fréquence (10), **caractérisé en ce que** l'oscillateur comporte :
- un modulateur (12) modulant les deux ondes optiques par une fréquence radio ou micro-onde, F_{RF}, la fonction de transfert du modulateur étant non linéaire pour générer des harmoniques de part et d'autre des fréquences des deux ondes optiques, correspondant à des fréquences **ν** +/- mF_{RF}, m étant égal à un entier et **ν** étant égal à **ν**ₒ ou **ν**ₑ,
- un détecteur optique (14) configuré à détecter au moins une harmonique pour chacune des ondes optiques générées par la source optique bi-fréquence et transformer les harmoniques détectées en un signal de battement,
- un comparateur de phase (15) pour comparer le signal électrique à un signal électrique de consigne,
- des moyens de commande (16) de l'une des fréquences ou des fréquences de la source optique bi-fréquence avec un signal obtenu à partir du signal résultant de la comparaison.

2. Oscillateur selon la revendication 1, **caractérisé en ce qu'**il comporte en outre des moyens de filtrage (13) du signal optique délivré par le modulateur.

3. Oscillateur selon la revendication 1 ou 2, **caractérisé en ce qu'**il comporte en outre des moyens d'amplification optique du signal optique délivré par le modulateur et/ou des moyens d'amplification du signal optique délivré par le modulateur et filtré.

4. Oscillateur selon l'une quelconque des revendications 1 à 3, **caractérisé en ce qu'**il comporte en outre des moyens (16) de filtrage et/ou d'amplification et/ou de déphasage du signal électrique résultant de la comparaison.

5. Oscillateur selon l'une quelconque des revendications 1 à 4, **caractérisé en ce que** la source optique bi-fréquence est un laser bi-fréquence (20) oscillant simultanément sur deux modes et **en ce que** l'élément de la source optique bi-fréquence commandé est un matériau électro optique intra-cavité.

6. Oscillateur selon l'une quelconque des revendications 1 à 4, **caractérisé en ce que** la source optique bi-fréquence est constituée de deux lasers monomodes, et **en ce que** l'élément de la source optique bi-fréquence commandé est un des lasers dont le courant d'injection est commandé ou dont le contrôleur de température est commandé ou l'élément de la source optique bi-fréquence commandé est un module piézo-électrique placé sur un des miroirs dudit laser.

7. Oscillateur selon l'une quelconque des revendications 1 à 6, **caractérisé en ce que** la sortie de la source optique bi-fréquence est reliée à une antenne (11).

8. Oscillateur selon l'une quelconque des revendications 1 à 8, **caractérisé en ce que** le modulateur (12) dont la fonction de transfert est non linéaire est un modulateur de Mach-Zehnder, un modulateur de phase, un amplificateur à semi conducteur modulé à F_{RF} via son courant d'injection ou via un battement optique, un résonateur optique de type Fabry-Perot comportant un modulateur de phase ou d'amplitude, un résonateur optique en anneau comportant un modulateur de phase ou d'amplitude.

9. Oscillateur selon l'une quelconque des revendications 1 à 9, **caractérisé en ce que** l'oscillateur comporte en outre un polariseur (17) pour générer un battement des ondes optiques.

## Patentansprüche

1. Oszillator, der eine Welle erzeugt, die aus einer Frequenz in der Größenordnung von Terahertz aus einer Schwebung von zwei Wellen mit den jeweiligen Frequenzen v₀ und vₑ, die von eine optischen Doppelfrequenzquelle (10) erzeugt werden, zusammengesetzt ist, **dadurch gekennzeichnet, dass** der Oszillator folgendes aufweist:
- einen Modulator (12), der die beiden optischen Wellen mit einer Funk- oder Mikrowellenfrequenz F_{RF} moduliert, wobei die Übertragungsfunktion des Modulators nichtlinear ist, um Harmonische beiderseits der Frequenzen der beiden optischen Wellen zu erzeugen, und zwar entsprechend Frequenzen v+/-mF_{RF}, wobei m gleich einer ganzen Zahl und v gleich v₀ oder vₑ ist,
- einen optischen Detektor (14), der derart konfiguriert ist, dass er mindestens eine Harmonische für jede der von der optischen Doppelfrequenzquelle erzeugten optischen Wellen erfasst und die erfassten Harmonischen in ein Schwebungssignal transformiert,
- einen Phasenkomparator (15), um das elektrische Signal mit einem elektrischen Sollsignal zu vergleichen,
- Mittel (16) zur Steuerung einer der Frequenzen oder der Frequenzen der optischen Doppelfrequenzquelle mit einem Signal, das aus dem Signal erhalten wurde, das aus dem Vergleich resultiert.

2. Oszillator nach Anspruch 1, **dadurch gekennzeichnet, dass** er ferner Mittel (13) zur Filterung des vom Modulator gelieferten optischen Signals umfasst.

3. Oszillator nach Anspruch 1 oder 2, **dadurch gekennzeichnet, dass** er ferner Mittel zur optischen Verstärkung des vom Modulator gelieferten optischen Signals und/oder Mittel zur Verstärkung des vom Modulator gelieferten und gefilterten optischen Signals umfasst.

4. Oszillator nach einem der Ansprüche 1 bis 3, **dadurch gekennzeichnet, dass** er ferner Mittel (16) zur Filterung und/oder Mittel (16) zur Verstärkung und/oder Mittel (16) zur Phasenverschiebung des aus dem Vergleich resultierenden elektrischen Signals umfasst.

5. Oszillator nach einem der Ansprüche 1 bis 4, **dadurch gekennzeichnet, dass** die optische Doppelfrequenzquelle ein Doppelfrequenzlaser (20) ist, der gleichzeitig auf zwei Moden oszilliert, und dass das gesteuerte Element der optischen Doppelfrequenzquelle ein elektro-optisches intrakavitäres Material ist.

6. Oszillator nach einem der Ansprüche 1 bis 4, **dadurch gekennzeichnet, dass** die optische Doppelfrequenzquelle aus zwei Monomodelasern gebildet ist und dass das gesteuerte Element der optischen Doppelfrequenzquelle einer der Laser ist, dessen Injektionsstrom gesteuert ist oder dessen Temperatursteuerung gesteuert ist, oder dass das gesteuerte Element der optischen Doppelfrequenzquelle ein piezoelektrisches Modul ist, das auf einem der Spiegel des Lasers angeordnet ist.

7. Oszillator nach einem der Ansprüche 1 bis 6, **dadurch gekennzeichnet, dass** der Ausgang der optischen Doppelfrequenzquelle an eine Antenne (11) angeschlossen ist.

8. Oszillator nach einem der Ansprüche 1 bis 7, **dadurch gekennzeichnet, dass** der Modulator (12), dessen Übertragungsfunktion nichtlinear ist, ein Mach-Zehnder-Modulator, ein Phasenmodulator, ein Halbleiterverstärker, der über seinen Injektionsstrom oder über eine optische Schwebung auf F_{RF} moduliert ist, ein optischer Resonator vom Fabry-Perot-Typ umfassend einen Phasen- oder Amplitudenmodulator, ein optischer Ringresonator umfassend einen Phasen- oder Amplitudenmodulator ist.

9. Oszillator nach einem der Ansprüche 1 bis 8, **dadurch gekennzeichnet, dass** der Oszillator ferner einen Polarisator (17) umfasst, um eine Schwebung der optischen Wellen zu erzeugen.

## Claims

1. Oscillator generating a wave composed of a frequency of the order of terahertz from the beat of two waves at respective frequencies υₒ and υₑ generated by a dual-frequency optical source (10), **characterised in that** the oscillator comprises:
- a modulator (12) which modulates the two optical waves by a radio or microwave frequency F_{RF}, the transfer function of the modulator being non-linear in order to generate harmonics on each side of the frequencies of the two optical waves, corresponding to frequencies υ +/- mF_{RF}, m being equal to an integer and υ being equal to υₒ or υₑ,
- an optical detector (14) configured to detect at least one harmonic for each of the optical waves generated by the dual-frequency optical source and to convert the detected harmonics into a beat signal,
- a phase comparator (15) for comparing the electrical signal with a reference electrical signal,
- control means (16) for controlling one of the frequencies or the frequencies of the dual-frequency optical source with a signal obtained from the signal resulting from the comparison.

2. Oscillator according to claim 1, **characterised in that** it further comprises filtering means (13) for filtration of the optical signal delivered by the modulator.

3. Oscillator according to claim 1 or 2, **characterised in that** it further comprises means for optical amplification of the optical signal delivered by the modulator and/or means for amplification of the optical signal delivered by the modulator and filtered.

4. Oscillator according to any one of claims 1 to 3, **characterised in that** it further comprises means (16) for filtration and/or amplification and/or phase shifting of the electrical signal resulting from the comparison.

5. Oscillator according to any one of claims 1 to 4, **characterised in that** the dual-frequency optical source is a dual-frequency laser (20) which oscillates on two modes simultaneously, and **in that** the element of the dual-frequency optical source that is controlled is an intra-cavity electrooptic material.

6. Oscillator according to any one of claims 1 to 4, **characterised in that** the dual-frequency optical source is composed of two monomode lasers, and **in that** the element of the dual-frequency optical source that is controlled is one of the lasers, the injection current of which is controlled or the temperature controller of which is controlled, or the element of the dual-frequency optical source that is controlled is a piezoelectric module placed on one of the mirrors of said laser.

7. Oscillator according to any one of claims 1 to 6, **characterised in that** the output of the dual-frequency optical source is connected to an antenna (11).

8. Oscillator according to any one of claims 1 to 8, **characterised in that** the modulator (12), the transfer function of which is non-linear, is a Mach-Zehnder modulator, a phase modulator, a semi-conductor amplifier modulated at F_{RF} *via* its injection current or *via* an optical beat, an optical resonator of the Fabry-Perot type comprising a phase or amplitude modulator, a ring-type optical resonator comprising a phase or amplitude modulator.

9. Oscillator according to any one of claims 1 to 9, **characterised in that** the oscillator further comprises a polariser (17) for generating a beat of the optical waves.
